# EUROPÄISCHE PATENTSCHRIFT

(11) **EP 2 643 858 B1**
(45) Veröffentlichungstag und Bekanntmachung des Hinweises auf die Patenterteilung: **15.07.2015**
(21) Anmeldenummer: 11784723.6
(22) Anmeldetag: 22.11.2011
(51) Int. Cl.: H01L 31/18, H01L 31/0236, H01L 31/0288, H01L 31/0725

(54) **HALBLEITERBAUELEMENT UND VERFAHREN ZU SEINER HERSTELLUNG**
SEMICONDUCTOR DEVICE AND MANUFACTURING METHOD THEREOF
DISPOSITIF SEMI-CONDUCTEUR ET SON PROCÉDÉ DE FABRICATION

(30) Priorität: 24.11.2010 DE 102010061831
(43) Veröffentlichungstag der Anmeldung: 02.10.2013
(73) Patentinhaber: Fraunhofer-Gesellschaft zur Förderung der angewandten Forschung e.V., 80686 München (DE)
(72) Erfinder: SCHADE, Wolfgang, 38644 Goslar (DE)
(74) Vertreter: Andrae | Westendorp Patentanwälte Partnerschaft
(86) Internationale Anmeldenummer: PCT/EP2011/070706
(87) Internationale Veröffentlichungsnummer: WO 2012/069488

(56) Entgegenhaltungen:
- US-A1- 2006 079 062
- US-A1- 2010 052 088
- US-B2- 7 057 256
- HOMMES V ET AL: "Silicon surface morphology study after exposure to tailored femtosecond pulses", APPLIED SURFACE SCIENCE, ELSEVIER, AMSTERDAM, NL, Bd. 252, Nr. 20, 15. August 2006 (2006-08-15), Seiten 7449-7460, XP024892207, ISSN: 0169-4332, DOI: 10.1016/J.APSUSC.2005.08.089 [gefunden am 2006-08-15]
- ZHU J T ET AL: "Effect of polarization on femtosecond laser pulses structuring silicon surface", APPLIED SURFACE SCIENCE, ELSEVIER, AMSTERDAM, NL, Bd. 252, Nr. 8, 15. Februar 2006 (2006-02-15), Seiten 2752-2756, XP024892387, ISSN: 0169-4332, DOI: 10.1016/J.APSUSC.2005.04.048 [gefunden am 2006-02-15]

## Beschreibung

Die Erfindung betrifft ein Verfahren zur Herstellung eines lichtabsorbierenden Halbleiterbauelementes, bei welchem zumindest eine Teilfläche eines Halbleitersubstrates mit einer Mehrzahl von Laserpulsen einer vorgebbaren Länge bestrahlt wird. Weiterhin betrifft die Erfindung ein Halbleiterbauelement zur Wandlung elektromagnetischer Strahlung in elektrische Energie, welches ein kristallines Halbleitersubstrat mit einer ersten Seite und einer gegenüberliegenden zweiten Seite enthält, wobei zumindest in einem an die erste Seite angrenzenden Teilvolumen des Halbleitersubstrates ein Dotierstoff eingebracht ist, sodass zwischen dem Teilvolumen und dem Halbleitersubstrat ein erster pn-Übergang ausgebildet ist. Halbleiterbauelemente der eingangs genannten Art können als photovoltaische Zellen zur Energieversorgung oder als Photodetektor zum Nachweis elektromagnetischer Strahlung verwendet werden.

Aus der WO 2006/086014 A2 ist ein Verfahren der eingangs genannten Art bekannt. Gemäß diesem bekannten Verfahren soll die Oberfläche eines Halbleitersubstrates unter Anwesenheit einer schwefelhaltigen Verbindung mit kurzen Laserpulsen von 50 fs bis 500 fs Dauer bestrahlt werden. Durch die nichtlineare Anregung des Halbleitersubstrates durch die Laserpulse wird die Oberfläche des Halbleitersubstrates teilweise umgeschmolzen und teilweise in einen gasförmigen Zustand überführt. Dadurch entsteht eine Oberflächenrauheit und eine polykristalline oder amorphe Phase. Daneben wird Schwefel als Dotierstoff in das Halbleitersubstrates eingebracht. Ein gemäß diesem bekannten Verfahren behandeltes Halbleitersubstrates zeigt eine gegenüber unbehandeltem Silizium erhöhte Lichtabsorption für Wellenlängen unterhalb der Bandlückenenergie. Der Wirkungsgrad der Energiewandlung von optischer in elektrische Energie beträgt dabei etwa 2,4 %.

US 2010/052088 offenbart ein Verfahren zur Herstellung eines Licht absorbierenden Halbleiterbauelementes, enthaltend den folgenden Schritt: Bestrahlen einer Teilfläche einer Seite eines Halbleitersubstrates mit einer Mehrzahl von Laserpulsen so dass zumindest die Teilfläche dieser Seite mit einer Oberflächenmodifikation versehen wird, wobei sich ein pn-Übergang mit einer Bandlückenenergie ausbildet,die geringer als die Bandlückenenergie des Halbleitersubstrates ist.

Ausgehend von diesen bekannten Verfahren liegt der Erfindung die Aufgabe zugrunde, den Wirkungsgrad einer photovoltaischen Zelle der eingangs genannten Art zu verbessern. Weiterhin liegt der Erfindung die Aufgabe zugrunde, eine effizientere Solarzelle bzw. einen empfindlicheren Photodetektor bereitzustellen.

Die Aufgabe wird erfindungsgemäß durch ein Verfahren gemäß Anspruch 1 und ein Halbleiterbauelement gemäß Anspruch 8 gelöst.

Erfindungsgemäß wurde erkannt, dass die Pulsform der Laserpulse, welche durch Modulation der Amplitude und/oder der Polarisation beeinflusst werden kann, Auswirkungen auf die Oberflächenstruktur, die entstehende polykristalline oder amorphe Materialphase, die Konzentration der Dotierstoffe und/oder deren elektrische Aktivität hat. Auf diese Weise können durch die Wahl der Pulsform die elektrischen Eigenschaften, die Oberflächenstruktur und/oder die Materialzusammensetzung in weiten Grenzen beeinflusst werden.

Erfindungsgemäß erfolgt die Oberflächenstrukturierung und/oder die Ausbildung bestimmter, vorgebbarer Phasen an der Oberfläche mit Laserpulsen von einigen Femtosekunden Dauer. Bei der Bestrahlung der Oberfläche des Halbleitersubstrates werden Elektronen des Festkörpers angeregt, wobei durch die hohen Pulsspitzenleistungen ein übersättigtes Elektronengas entsteht. Dabei wird das Halbleitersubstrat lokal ionisiert. Schließlich wird die Energie des Elektronengases an das Kristallgitter abgegeben, was zur Ablation bzw. Verdampfung eines Teils des Materials führt. Die abgedampfte Masse bildet einen Partikelstrom, welcher sich mit Geschwindigkeiten bis 10³ m·s⁻¹ ausbreitet. Innerhalb des Partikelstromes entsteht eine Rückstoßwelle durch die Dichteänderung innerhalb der Gasphase. Diese Stoßwelle propagiert ebenfalls in eine von der Oberfläche des Halbleitersubstrates abgewandte Richtung, jedoch mit einer größeren Geschwindigkeit als der Partikelstrom. Daher wird die Stoßwelle an der Grenzfläche des Partikelstroms zur umgebenden Atmosphäre reflektiert. Beim erneuten Auftreffen der Schockwelle auf die Oberfläche des Halbleitersubstrates koppelt diese in die flüssige Oberflächenschicht ein. Dadurch kommt es zu Dichteänderungen in der Oberflächenschicht, welche bei der Abkühlung der flüssigen Schicht zur Bildung von polykristallinem und/oder amorphem Material an der Oberfläche führt.

Es wurde erkannt, dass die Oberfläche bereits nach etwa 500 ps erstarrt, sodass dieser Prozess bei jedem eintreffenden Laserpuls wieder von neuem beginnt. Erfindungsgemäß wird nun vorgeschlagen, die Pulsform der Laserpulse so an eine vorgebbare Sollform anzupassen, dass innerhalb eines Laserpulses mehrere Energieeinträge unmittelbar nacheinander erfolgen, bevor die Oberfläche wieder vollständig erstarrt ist. Auf diese Weise ist es möglich, mehrere interne Schockwellen mit fest definierter zeitlicher Dynamik zu erzeugen, sodass die Bildung der polykristallinen Oberflächenschicht gezielt manipuliert oder verhindert werden kann. Auf diese Weise entstehen bei dem erfindungsgemäßen Verfahren größere Kristallite mit geringeren Oberflächen-/Volumenverhältnissen, sodass die Zahl der Rekombinationszentren verringert wird. Dadurch wird der erzeugte Photostrom und schließlich der Wirkungsgrad einer Solarzelle oder die Sensitivität eines Photodetektors erhöht.

Ein lichtabsorbierendes Halbleiterbauelement im Sinne der vorliegenden Erfindung ist dazu eingerichtet, Photonen zu absorbieren und eine Ladungstrennung im Halbleitermaterial zu bewirken. Die auf diese Weise erzeugten Nichtgleichgewichtsladungsträger können in einigen Ausführungsformen der Erfindung als elektrischer Strom- bzw. elektrische Spannung an Anschlusselementen des Bauelementes bereitgestellt werden.

In einigen Ausführungsformen der Erfindung kann vorgesehen sein, dass das Halbleitersubstrat einer schwefelhaltigen Verbindung ausgesetzt wird, während zumindest ein Laserpuls auf die Oberfläche des Substrates auftrifft. In diesem Fall kann die schwefelhaltige Verbindung durch die auftreffende Laserstrahlung dissoziiert werden, sodass Schwefelatome in eine oberflächennahe Schicht des Halbleitersubstrates eingebaut werden. In einigen Ausführungsformen der Erfindung kann auf diese Weise eine n-Dotierung erzeugt werden, sodass sich an der bestrahlten Oberfläche eines p-dotierten Halbleitersubstrates ein pn-Übergang ausbilden kann. In einigen Ausführungsformen der Erfindung kann die Dotierung eine Vielzahl elektronischer Zustände innerhalb der Bandlücke ausbilden, so dass ein Zwischenband elektronischer Zustände innerhalb der Bandlücke des Halbleitermaterials ausgebildet wird. Dadurch kann die Absorption von Photonen mit einer Energie kleiner als die Bandlückenenergie des Halbleitersubstrates ermöglicht oder zumindest verbessert werden.

In einigen Ausführungsformen der Erfindung kann die vorgebbare Länge eines Laserpulses etwa 10 fs bis etwa 1 ns betragen. Die Länge der Laserpulse bezeichnet dabei im Sinne der vorliegenden Beschreibung die Gesamtlänge eines Pulses, wobei einzelne Pulse einen zeitlichen Abstand von 10 µs bis 100 ns haben können. Davon zu unterscheiden ist die Substruktur der Amplitude und/oder der Phase innerhalb eines Pulses, welche auf erheblich kürzerer Zeitskala variieren kann, beispielsweise innerhalb von 0.1 fs - 1.0 fs oder innerhalb von 1 fs - 10 fs.

In einigen Ausführungsformen der Erfindung kann die Repetitionsrate zwischen 1 kHz und 10 MHz liegen. Die Repetitionsrate beschreibt dabei den zeitlichen Abstand zweier Laserpulse. Demgegenüber kann die Substruktur eines einzelnen Pulses mit einer Frequenz von einigen THz (10¹² Hz) variieren. Die gewählten Werte stellen einerseits sicher, dass die Oberfläche des Halbleitersubstrates nach dem Auftreffen eines einzelnen Laserpulses vollständig relaxiert, d.h. in einem thermodynamisch stabilen Zustand zurückkehrt. Demgegenüber können einzelne Amplitudenmaxima der Substruktur eines Laserpulses an die gebundenen Elektronen und/oder das Gitter des Halbleitersubstrates in einem angeregten Zustand ankoppeln, sodass die kohärente Kontrolle des durch das Halbleitersubstrat gebildeten quantenmechanischen Systems ermöglicht wird. Dies erlaubt die Beeinflussung der Oberflächenstruktur, der entstehenden polykristallinen oder amorphen Materialphase, der Konzentration der Dotierstoffe und/oder deren elektrischen Aktivität durch die Wahl der Pulsform der Laserpulse.

In einigen Ausführungsformen der Erfindung kann die Herstellung des lichtabsorbierenden Halbleiterbauelementes durch Bestrahlung mit einer einzigen, vorgebbaren Pulsform der Laserpulse folgen. In anderen Ausführungsformen der Erfindung kann sich das Verfahren zur Herstellung eines lichtabsorbierenden Halbleiterbauelementes in eine Mehrzahl von Herstellungsschritten gliedern, wobei in zumindest zwei Herstellungsschritten unterschiedliche Pulsform der Laserpulse verwendet werden. Dies ermöglicht beispielsweise die Dotierung mittels Fremdatomen mit einer ersten Pulsform und die Schaffung einer vorgebbaren Oberflächenstruktur mittels einer zweiten Pulsform, welche von der ersten Pulsform verschieden ist. Auf diese Weise kann in jedem Verfahrensschritt ein optimiertes Ergebnis erhalten werden.

In einigen Ausführungsformen der Erfindung kann die Amplitude eines einzelnen Laserpulses so moduliert sein, dass diese drei Maxima aufweist, wobei zumindest ein Maximum eine erste Amplitude aufweist und zumindest ein Maximum eine zweite Amplitude aufweist, welche von der ersten Amplitude verschieden ist. In einigen Ausführungsformen der Erfindung kann die Amplitude zwischen den Maxima für eine Zeitspanne von weniger als 5 fs auf einen Wert von weniger als 15 % der ersten und/oder der zweiten Amplitude abfallen. Eine solche Verfahrensführung ermöglicht einen Materialabtrag aus einem angeregten Zustand der oberflächennahen Elektronen des Halbleitersubstrates. Weiterhin kann die beschriebene Verfahrensführung bewirken, dass eine verflüssigte Oberflächenschicht des Halbleitersubstrates durch das elektrische Feld des Laserpulses in eine günstige atomaren Anordnung gebracht wird, ehe diese rekristallisiert bzw. verfestigt. Auf diese Weise kann in einigen Ausführungsformen der Erfindung eine polykristalline Oberflächenschicht entstehen, welche größere Kristallite mit geringerem Oberflächen-/Volumenverhältnis aufweist. In einigen Ausführungsformen der Erfindung kann das Entstehen einer polykristallinen Oberflächenschicht auch verhindert werden. Schließlich kann in einigen Ausführungsformen der Erfindung durch die Wahl der Sollform der Laserpulse die Oberflächentextur des Halbleitersubstrates beeinflusst werden.

In einigen Ausführungsformen der Erfindung kann in einem nachfolgenden Verfahrensschritt zumindest eine Teilfläche des Halbleitersubstrates mit einer Kontaktschicht versehen sein. Die Kontaktschicht kann ein Metall oder eine Legierung enthalten. In einigen Ausführungsformen der Erfindung kann die Kontaktschicht einen mehrschichtigen Aufbau aufweisen und aus mehreren, dünnen Einzelschichten zusammengesetzt sein.

In einigen Ausführungsformen der Erfindung kann die Kontaktschicht auf dem Halbleitersubstrat einen ohmschen Kontakt ausbilden. Auf diese Weise können während des Betriebes erzeugte Ladungsträger im Halbleiterbauelement durch Anlegen einer elektrischen Spannung separiert und als elektrischer Strom nachgewiesen bzw. genutzt werden. Sofern eine Teilfläche des Halbleitersubstrates mit der Kontaktschicht versehen ist, können andere Flächenbereiche bzw. Teilflächen des Halbleitersubstrates während des Betriebes des Halbleiterbauelementes zur Einkopplung von Licht verwendet werden. Sofern ein Halbleitersubstrat Flächenbereiche aufweist, welche durch Einstrahlen einer Mehrzahl von Laserpulsen einer vorgebbaren Länge und Pulsform bearbeitet wurden, sowie andere Flächenbereiche, welche nicht entsprechend bearbeitet wurden, können unterschiedliche Kontaktschichten vorgesehen sein, welche entweder die einen oder die anderen Flächenbereiche kontaktieren. Hierzu können die unterschiedlichen Kontaktschichten unterschiedliche stoffliche Zusammensetzungen und/oder unterschiedliche Bindungsverhältnisse aufweisen.

In einigen Ausführungsformen der Erfindung kann das Halbleitersubstrat nach der Bestrahlung mit einer Mehrzahl von Laserpulsen getempert werden. Dadurch können in einigen Ausführungsformen der Erfindung Defektzustände des Kristallgitters ausheilen und/oder Dotierstoffe innerhalb des Halbleitersubstrates diffundieren und/oder Dotierstoffe elektronisch aktiviert werden. In einigen Ausführungsformen der Erfindung kann das Halbleiterbauelement verbesserte elektrische Eigenschaften aufweisen, wenn das Halbleitersubstrat nach der Bestrahlung mit einer Mehrzahl von Laserpulsen getempert wurde.

In einigen Ausführungsformen der Erfindung kann die durch die Bestrahlung mit einer Mehrzahl von Laserpulsen vorgebbare Pulsform erhaltene Oberflächenmodifikation eine Mehrzahl säulenförmiger Erhebungen aufweisen, welche einen Durchmesser von etwa 0,3 µm bis etwa 1 µm und eine Längserstreckung in Richtung der Flächennormalen von etwa 1 µm bis etwa 5 µm aufweist. Säulenförmige Erhebungen der genannten Art können einerseits die Lichtabsorption verbessern, sodass die Quanteneffizienz eines erfindungsgemäßen Halbleiterbauelementes ansteigt. Daneben erlauben Erhebungen der genannten Art eine einfache Kontaktierbarkeit durch eine Kontaktschicht, sodass die Haftfähigkeit über die Lebensdauer des Halbleiterbauelementes gesichert ist.

In einigen Ausführungsformen der Erfindung kann das Halbleitersubstrat p-dotiertes Silizium enthalten oder daraus bestehen und der Dotierstoff ausgewählt sein aus Stickstoff und/oder Phosphor und/oder Arsen und/oder Schwefel. Auf diese Weise kann durch Bestrahlen der Oberfläche des Halbleiterbauelementes mit einer Mehrzahl von Laserpulsen vorgebbarer Sollform unter Anwesenheit einer stickstoffhaltigen, phosphorhaltigen, schwefelhaltigen oder arsenhaltigen Verbindung ein pn-Übergang erhalten werden, wenn die Verbindung durch die Laserstrahlung dissoziiert und die Dotierstoffe nachfolgend in das Material des Halbleitersubstrates eingebaut werden. Sofern die Pulsform der Laserpulse an das Absorptionsschema der zur Dotierung verwendeten Verbindung angepasst ist, kann die Dissoziation durch kohärente Kontrolle erfolgen, sodass der Einbau des Dotierstoffes in vorgebbarer Weise erfolgt.

In einigen Ausführungsformen der Erfindung kann das vorgeschlagene Halbleiterbauelement zumindest eine photovoltaische Zelle enthalten oder aus zumindest einer photovoltaischen Zelle bestehen. In diesem Fall kann die Kontaktschicht der ersten Seite des Halbleitersubstrates mit einer ersten Kontaktschicht auf der zweiten Seite eine erste photovoltaische Zelle bilden und die Kontaktschicht der ersten Seite zusammen mit einer zweiten Kontaktschicht der zweiten Seite eine zweite photovoltaische Zelle bilden, welche monolithisch auf einem Halbleitersubstrat integriert sind. Auf diese Weise können zwei photovoltaischen Zellen, welche Licht unterschiedlicher Wellenlänge absorbieren, auf einem einzigen Halbleitersubstrat realisiert werden, sodass der Gesamtwirkungsgrad der photovoltaischen Zelle steigt. Die beiden monolithisch auf einem Halbleitersubstrat integrierten photovoltaischen Zellen können unabhängig voneinander kontaktiert werden, in einer Parallelschaltung miteinander verbunden werden, um den Ausgangsstrom zu erhöhen oder in einer Serienschaltung miteinander verbunden werden, um die Ausgangsspannung des Halbleiterbauelementes zu erhöhen.

Nachfolgend soll die Erfindung anhand von Figuren ohne Beschränkung des allgemeinen Erfindungsgedankens näher erläutert werden. Dabei zeigt:
- Figur 1: ein erstes Ausführungsbeispiel einer Pulsform der Laserpulse, welche zur Herstellung eines lichtabsorbierenden Halbleiterbauelementes verwendet werden können.
- Figur 2: zeigt ein zweites Ausführungsbeispiel einer Pulsform der Laserpulse, welche zur Herstellung eines lichtabsorbierenden Halbleiterbauelementes verwendet werden können.
- Figur 3: zeigt die Wellenlängenabhängigkeit der Absorption eines erfindungsgemäßen Halbleiterbauelementes, bei welchem unterschiedliche Pulsformen der Laserpulse zur Herstellung verwendet wurden.
- Figur 4: zeigt einen Querschnitt durch ein Halbleiterbauelement gemäß einer Ausführungsform der Erfindung.
- Figur 5: zeigt die Aufsicht auf die Unterseite eines Halbleiterbauelementes gemäß der vorliegenden Erfindung.
- Figur 6: zeigt schematisch den Aufbau einer Vorrichtung zur Herstellung eines Halbleiterbauelementes gemäß der vorliegenden Erfindung.
- Figur 7: zeigt ein Flussdiagramm des erfindungsgemäß vorgeschlagenen Verfahrens.
- Figur 8: zeigt die Vor- und Rückseite und den Querschnitt einer erfindungsgemäßen und einer bekannten Solarzelle.
- Figur 9: zeigt zwei REM-Aufnahmen von zwei Silizium-Oberflächen, welche mit unterschiedlichen Laserpulsen behandelt wurden.

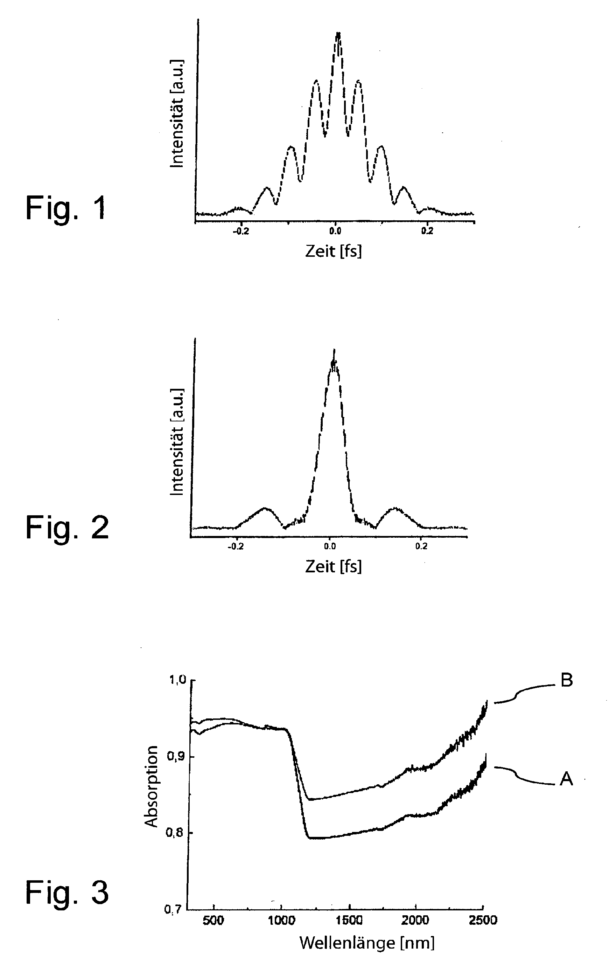

Figur 1 zeigt die Intensität ausgesandten Laserlichtes auf der Ordinate und die Zeit in Femtosekunden auf der Abszisse. Dargestellt ist der Verlauf der Lichtamplitude einer beispielhaften Pulsform eines Laserpulses, welcher im vorgeschlagenen Verfahren zur Herstellung eines lichtabsorbierenden Halbleiterbauelementes verwendbar ist. Der Amplitudenverlauf zeigt acht Maxima, welche in etwa äquidistant innerhalb von 0,4 fs ausgesandt werden. Der Absolutwert der Amplitude eines jeden Maximums ist größer als der Maximalwert des vorhergehenden Maximums. Dazwischen fällt die Amplitude auf einen ebenfalls ansteigenden Minimalwert ab.

Nach Erreichen des Maximalwertes wird die Amplitude in einem etwa spiegelbildlichen Kurvenverlauf wieder auf den Ausgangswert zurückgeführt. Nach einer Pause vorgebbarer Länge kann der in Figur 1 dargestellte Kurvenverlauf zyklisch wiederholt werden. Bei dem in Figur 1 dargestellten Kurvenverlauf kann es sich um den zeitlichen Verlauf der Amplitude eines Laserpulses handeln oder um einen Ausschnitt aus einem Laserpuls, welcher gesamt eine größere zeitliche Ausdehnung aufweist.

Figur 2 zeigt eine zweite Ausführungsform einer Pulsform gemäß der vorliegenden Erfindung. Im Ausführungsbeispiel gemäß Figur 2 ist ein Kurvenverlauf mit drei Maxima vorgesehen, wobei im zentralen Bereich des Kurvenverlaufes ein Maximum großer Amplitude erreicht wird, welches von zwei Maxima mit kleinerer Amplitude flankiert wird. Dazwischen fällt der Kurvenverlauf auf einen Wert nahe des Nullwertes ab. In einigen Ausführungsformen der Erfindung kann der Minimalwert weniger als 10 % des benachbarten Maximalwertes umfassen, weniger als 5 % oder weniger als 1 %. In einigen Ausführungsformen der Erfindung kann die Amplitude im Minimum auf null absinken.

In gleicher Weise wie anhand der Figuren 1 und 2 exemplarisch für die Amplitude bzw. die Intensität gezeigt, kann auch die Polarisation eines Laserpulses in einem vorgebbaren Muster bzw. einer vorgebbaren Sollform moduliert werden.

Figur 3 zeigt das Absorptionsvermögen eines erfindungsgemäß vorgeschlagenen Halbleiterbauelementes. Das Halbleiterbauelement enthält dabei ein Halbleitersubstrat, welches im Wesentlichen aus Silizium besteht. Daneben kann das Halbleitersubstrat übliche Verunreinigungen und/oder Dotierstoffe enthalten. Das Halbleitersubstrat wurde mit einer Mehrzahl von Laserpulsen vorgebbarer Pulsform bei bestrahlt und dabei einer schwefelhaltigen Verbindung ausgesetzt. Auf diese Weise entsteht zumindest eine Teilfläche mit einer Oberflächenmodifikation, welche eine veränderte Oberflächenstruktur, eine polykristalline oder amorphe Materialphase, und/oder eine vorgebbare Schwefelkonzentration aufweisen kann.

In Figur 3 ist nun die Absorption auf der Ordinate gegen die Wellenlänge auf der Abszisse dargestellt. Dabei zeigt Kurve A den Verlauf der Absorption eines Halbleitersubstrates, welches mit Laserpulsen bearbeitet wurde, deren Pulsform in Figur 1 dargestellt ist. Kurve B zeigt den Verlauf der Absorption für ein Halbleitersubstrat, bei dessen Bearbeitung Laserpulse mit der in Figur 2 gezeigten Pulsform eingesetzt wurden.

Aus Figur 3 ist erkennbar, dass für Wellenlängen kleiner als 1100 nm die Absorption bei einem Wert von etwa 0,95 liegt. Diese Absorption ist auf elektronische Anregungen zwischen Valenz- und Leitungsband des verwendeten Siliziums zurückzuführen. Sofern die Photonenenergie unter die Bandlückenenergie sinkt, nimmt die Absorption rasch ab. Infrarotes Licht kann nun an den durch die Bestrahlung mit den Laserpulsen modifizierten Oberflächenbereichen auftreten. Dabei ist die Absorption gemäß Kurvenverlauf A stets geringer als die Absorption gemäß dem Kurvenverlauf B. Durch die erfindungsgemäße Modulation der Amplitude und/oder der Polarisation der zur Materialbearbeitung eingesetzten Laserpulse kann demnach das Absorptionsverhalten eines Halbleiterbauelementes für Photonenenergien unterhalb der Bandlückenenergie erheblich verbessert werden. Hierdurch kann der Wirkungsgrad einer mit dem vorgeschlagenen Verfahren hergestellten Solarzelle bzw. die Sensitivität eines mit dem erfindungsgemäßen Verfahren hergestellten Photodetektors gesteigert werden.

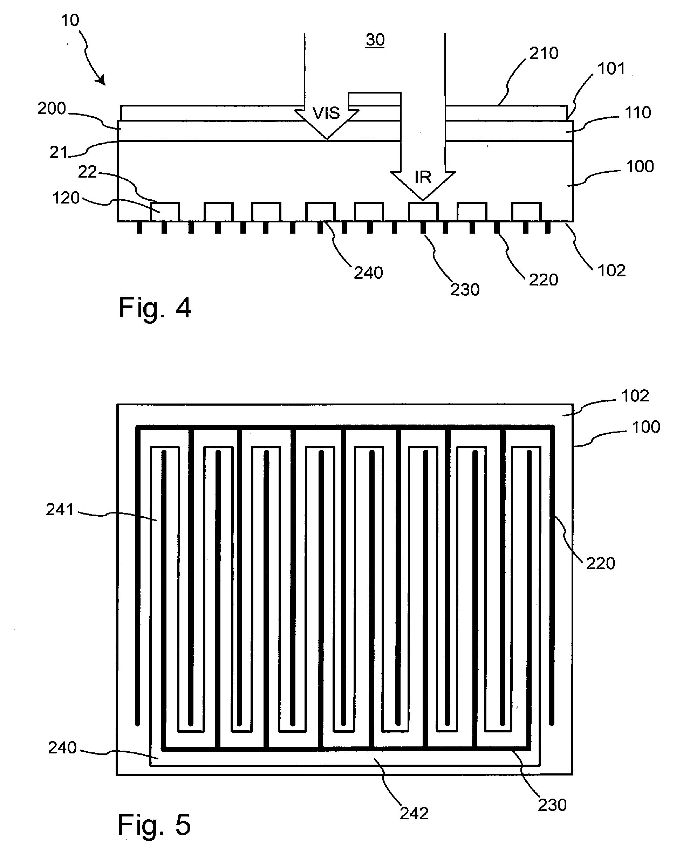

Figur 4 zeigt einen Querschnitt durch eine erfindungsgemäß vorgeschlagene, monolithische Tandemsolarzelle. Die Solarzelle ist auf einem Substrat 100 aufgebaut. Das Substrat 100 kann Silizium enthalten oder daraus bestehen. Daneben kann das Substrat 100 unvermeidbare Verunreinigungen enthalten, beispielsweise Kohlenstoff, Sauerstoff oder Wasserstoff. In einigen Ausführungsformen der Erfindung kann das Substrat 100 p-leitfähig sein. Hierzu kann das Substrat 100 dotiert sein, beispielsweise mit Gallium, Aluminium oder Bor. Das Substrat 100 weist eine erste Oberfläche 101 und eine gegenüberliegende zweite Oberfläche 102 auf. Die Dicke des Substrates 100 kann in einigen Ausführungsformen der Erfindung etwa 50 µm bis etwa 1000 µm betragen.

In einem an die erste Seite 101 angrenzenden Teilvolumen 110 kann ein Dotierstoff eingebracht werden, welcher eine n-Leitfähigkeit des Teilvolumens 110 bewirkt. Als Dotierstoff können in einigen Ausführungsformen Stickstoff, Phosphor oder Arsen verwendet werden. Das Teilvolumen 110 kann eine Dicke von etwa 2 % bis etwa 20 %, in einigen Ausführungsformen etwa 5 % bis etwa 10 % der Dicke des Substrates 100 aufweisen.

An der Grenzfläche zwischen dem Teilvolumen 110 und dem verbleibenden Volumen des Substrates 100 bildet sich auf diese Weise ein erster pn-Übergang 21 aus.

Auf der ersten Seite 101 ist zumindest eine Kontaktschicht 210 angeordnet. Die Kontaktschicht 210 kann als Teilbeschichtung der ersten Seite 101 ausgeführt sein, sodass unbedeckte Bereiche der ersten Seite 101 verbleiben, durch welche bei Betrieb der Solarzelle Lichtstrahlung 30 in das Volumen des Substrates 100 eindringen kann. Im dargestellten Ausführungsbeispiel weist die Kontaktschicht 210 ein Streifen- bzw. Gittermuster auf, welches quer zur Schnittebene verläuft. Daher ist die Kontaktschicht 210 in Figur 4 durchgängig dargestellt. Unbedeckte Teilflächen der ersten Oberfläche befinden sich dann vor- und hinter der Zeichenebene

Die gegenüberliegende zweite Seite 102 des Substrates 100 wurde bei Anwesenheit einer schwefelhaltigen Verbindung, beispielsweise SF₆ oder H₂S mit Laserpulsen einer vorgebbaren Dauer zwischen etwa 10 fs bis etwa 1 ns, insbesondere etwa 50 fs bis etwa 500 fs bestrahlt. Die Laserpulse weisen dabei eine vorgebbare Pulsform auf, welche durch Modulation der Amplitude und/oder der Polarisation erhalten wird. In Abhängigkeit der Pulsform, der Intensität, der Repetitionsrate und/oder der Anzahl der Einzelpulse sowie in Abhängigkeit der Konzentration der schwefelhaltigen Verbindung entstehen unterhalb der bestrahlten Flächenbereiche 240 Teilvolumina 120, in welchen die chemische Zusammensetzung und/oder die Phase des Materials des Substrates 100 modifiziert ist.

Beispielsweise kann in den Teilvolumina 120 eine Schwefelkonzentration vorliegen, welche die Ausbildung eines Defektbandes in der Bandlücke des Halbleitersubstrates 100 bewirkt. In einigen Ausführungsformen kann in den Teilvolumina 120 ein polykristallines Material oder ein amorphes Material vorliegen. Schließlich kann die Oberfläche 240 strukturiert sein, sodass sich säulenförmig von der Oberfläche 102 abstehende Flächenbereiche mit einem Durchmesser von 0,3 µm bis 1 µm und einer Länge von 1 µm bis 5 µm ausbilden. Die Teilvolumina 120 können entlang des Normalenvektors der zweiten Seite 102 eine Längsausdehnung von 2 µm bis 20 µm aufweisen.

An der Grenzfläche des Teilvolumens 120 zum Inneren des Substrates 100 bildet sich ein zweiter pn-Übergang 22 aus.

Auf der zweiten Seite 102 befinden sich weiterhin eine zweite Kontaktschicht 220, welche die nicht durch die Laserpulse bearbeiteten Flächenbereiche der zweiten Seite 102 zumindest teilweise bedeckt.

Weiterhin ist auf der zweiten Seite 102 eine dritte Kontaktschicht 230 angeordnet, welche die mit der Laserstrahlung bearbeiteten Flächenbereiche 240 zumindest teilweise bedeckt.

Die Kontaktschichten 210, 220 und 230 können ein Metall oder eine Legierung enthalten oder daraus bestehen. In einigen Ausführungsformen der Erfindung können die Kontaktschichten 210, 220 und 230 einen mehrschichtigen Aufbau aufweisen.

Bei Betrieb des Halbleiterbauelementes gemäß Figur 1 trifft Sonnenlicht oder Kunstlicht 30 auf die erste Seite 101 des Substrates 100 auf. Das Sonnenlicht kann in das Substrat 100 durch die erste Seite 101 eindringen. Am ersten pn-Übergang 21 wird der sichtbare Anteil des Sonnenlichtes 30, also der Anteil mit einer Wellenlänge von weniger als 1100 nm bzw. einer Photonenenergie oberhalb der Bandlückenenergie, absorbiert. Die Absorption des Lichtes bewirkt eine Ladungstrennung, d.h. eine Anregung von Elektronen aus dem Valenz- ins Leitungsband. Über die erste Kontaktschicht 210 und die zweite Kontaktschicht 220 können die separierten Ladungsträger als Strom aus dem Halbleiterbauelement entnommen werden.

Der infrarote Anteil des Lichtes 30, d.h. Licht mit einer Wellenlänge von mehr als etwa 1100 nm, durchdringt das Substrat 100, da die Photonenenergie niedriger ist als die Bandlückenenergie. Das Substrat 100 sowie das Teilvolumen 110 erscheinen für dieses infrarote Licht nahezu transparent. Das infrarote Licht gelangt auf den zweiten pn-Übergang 22, welcher aufgrund der Dotierung mit Schwefelatomen und/oder der Einwirkung der ultrakurzen Laserpulse bei der Fertigung elektronische Zustände in der Bandlücke ausbildet. Hierdurch verringert sich die effektive Bandlücke, so dass das infrarote Licht am zweiten pn-Übergang 22 absorbiert werden kann. Hierbei entstehen wiederum freie Ladungsträger, welche über die erste Kontaktschicht 210 und die dritte Kontaktschicht 230 als Strom aus dem Halbleiterbauelement entnommen werden können.

Anders als herkömmliche Siliziumsolarzellen kann das erfindungsgemäß vorgeschlagene Bauelement somit auch den infraroten Anteil des Sonnenspektrums zumindest teilweise zur Energiegewinnung nutzen. Dieser infrarote Anteil beträgt etwa ein Drittel der eingestrahlten Gesamtintensität. Auf diese Weise steigen der Wirkungsgrad und die Energieausbeute der Solarzelle an. Anders als bisher bekannte Tandemsolarzellen, welche den infraroten Anteil des Spektrums in einem Material kleinerer Bandlücke absorbieren, wie beispielsweise Galliumarsenid, kann die erfindungsgemäß vorgeschlagene Solarzelle monolithisch auf einem einzigen Substrat aufgebaut werden, sodass sich ein mechanisch robuster und kostengünstiger Aufbau ergibt. In einigen Ausführungen der Erfindung kann die bei Betrieb eines Gerätes entstehende Wärmestrahlung zumindest teilweise in elektrische Energie gewandelt werden.

Figur 5 zeigt die zweite Seite 102 des Substrates 100 in der Aufsicht. Erkennbar sind die Flächenbereiche 240, welche durch Bestrahlung mit Laserpulsen vorgebbarer Pulsform modifiziert wurden, um die Absorption infraroten Lichtes zu ermöglichen. Der Flächenbereich 240 weist im dargestellten Ausführungsbeispiel eine kammartige Grundform auf, mit einer Mehrzahl von länglichen Flächenbereichen 241, welche durch einen in etwa orthogonal verlaufenden Bereich 242 miteinander verbunden sind.

Die dritte Kontaktschicht 230 bedeckt eine Teilfläche der modifizierten Fläche 240, wobei die dritte Kontaktschicht 230 in etwa mittig auf den Symmetrieachsen der Flächenbereiche 241 und 242 angeordnet ist.

Auch die zweite Kontaktschicht 220 weist eine kammartige Grundform auf, wobei die Kontaktschicht 220 in die Zwischenräume zwischen zweier benachbarter Flächenbereiche 241 eingreift. Selbstverständlich ist die in Figur 5 dargestellte Interdigitalstruktur lediglich beispielhaft zu verstehen. In anderen Ausführungsformen der Erfindung kann die laterale Strukturierung der Kontaktschichten 220 und 230 sowie die Grundfläche der durch die Laserpulse modifizierten Fläche 240 auch anders gewählt sein.

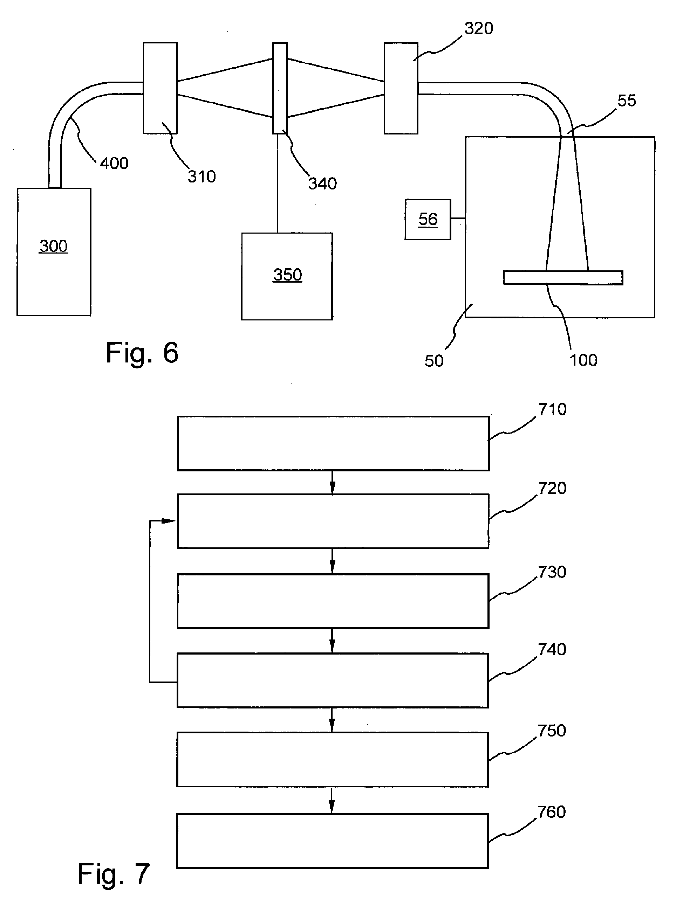

Figur 6 zeigt exemplarisch eine Vorrichtung zur Herstellung der erfindungsgemäß vorgeschlagenen Halbleiterbauelemente. In Figur 6 ist eine Vakuumkammer 50 dargestellt, welche das Halbleitersubstrat 100 aufnimmt. Der Innenraum der Vakuumkammer 50 kann mittels einer nicht dargestellten Vakuumpumpe evakuiert werden, beispielsweise auf einen Druck von weniger als 10⁻² mbar, weniger als 10⁻⁴ mbar, weniger als 10⁻⁶ mbar oder weniger als 10⁻⁸ mbar.

An der Vakuumkammer 50 ist ein Gasversorgungssystem 56 angeschlossen. Das Gasversorgungssystem 56 dient dazu, eine gasförmige, schwefelhaltige Verbindung mit vorgebbarem Druck und/oder Zusammensetzung in die Kammer 50 einzulassen. Beispielsweise kann das Gasversorgungssystem 56 SF₆ und/oder H₂S in den Innenraum der Vakuumkammer 50 einlassen. Der Druck kann zwischen 1200 mbar und 10⁻³ mbar betragen. Der Druck und/oder der Massenfluss kann durch entsprechende Regeleinrichtungen auf vorgebbaren Werten gehalten werden.

Die Vakuumkammer 50 weist zumindest ein Eintrittsfenster 55 auf, durch welches Laserpulse einer vorgebbaren Pulsform in den Innenraum der Vakuumkammer einkoppeln können, um nachfolgend auf dem Halbleitersubstrat 100 Oberflächenmodifikationen und/oder Dotierungen zu bewirken.

Die Laserpulse 400 werden durch einen an sich bekannten Femtosekundenlaser 300 erzeugt. Der Femtosekundenlaser kann beispielsweise einen Titansaphirlaser enthalten. Die Mittenfrequenz der Laserpulse kann durch Frequenzvervielfachung an eine vorgebbare Sollfrequenz angepasst werden. Die Pulsdauer eines einzelnen Laserpulses kann in einigen Ausführungsformen der Erfindung zwischen 10 fs und 1 ns betragen. In einigen Ausführungsformen der Erfindung kann die Pulsdauer 10 fs bis etwa 50 fs betragen oder etwa 50 fs bis etwa 500 fs.

Zur Erzeugung einer gewünschten Pulsform werden die Laserpulse 400 in einem ersten dispersiven Element 310 spektral aufgespalten. Das dispersive Element 310 kann beispielsweise ein Gitter oder ein Prisma enthalten. Die Laserpulse 400 werden nach dem ersten dispersiven Element 310 auf einen Zwischenfokus abgebildet, in welchem ein Manipulator 340 angeordnet ist. Danach wird das Licht einem zweiten dispersiven Element 320 zugeführt, dessen Wirkung invers zur Wirkung des ersten dispersiven Elementes 310 ist.

Der Manipulator 340 kann beispielsweise einen räumlichen Lichtmodulator und/oder zumindest einen Polarisator enthalten. Auf diese Weise können durch Ändern der der Polarisation und/oder der Amplitude und/oder der Phase die Pulsform bzw. die zeitliche Substruktur der von der Laserlichtquelle 300 ausgesandten Lichtpulse 400 verändert werden. Das Ändern der zeitlichen Substruktur ist dabei in einfacher Weise und mit nur kurzen Schaltzeiten möglich. Erfindungsgemäß wurde erkannt, dass die Wellenlänge des Lasers weitgehend unerheblich ist. Entscheidend für die Oberflächenmodifikation des Substrates 100 ist überwiegend die zeitliche Substruktur der Laserpulse 400.

Der Manipulator 340 wird von einer Kontrolleinrichtung 350 angesteuert, welche in einigen Ausführungsformen der Erfindung auch einen Regelkreis enthalten kann, um die zeitliche Substruktur der Pulse 400 an eine vorgebbare Sollform anzupassen. Aufgrund der kurzen Schaltzeiten kann die Oberflächenmodifikation des Substrates 100 in Abhängigkeit des gewünschten Ergebnisses mit einer einzigen Pulsform oder mit einer Mehrzahl unterschiedlicher Pulsformen erfolgen, welche sequenziell angewendet werden.

Figur 7 illustriert nochmals in Form eines Flussdiagrammes das erfindungsgemäße Herstellungsverfahren. Im ersten Verfahrensschritt 710 wird ein kristallines Halbleitersubstrat bereitgestellt, welches mit einer ersten Seite und einer gegenüberliegenden zweiten Seite versehen ist. Zumindest in einem an die erste Seite angrenzenden Teilvolumen ist ein Dotierstoff eingebracht, sodass sich in dem Halbleitersubstrat ein erster pn-Übergang ausbildet. Das Halbleitersubstrat kann in einigen Ausführungsformen der Erfindung mit einem Dotierstoff versehen sein. Auch kann das Halbleitersubstrat bereits im ersten Verfahrensschritt 710 mit einer ersten Kontaktschicht 210 versehen sein, welche den später im Betrieb entstehenden Strom von der ersten Seite 101 abführt.

Das Substrat 100 wird mit einer schwefelhaltigen Verbindung vorgebbarer Zusammensetzung und Konzentration in Kontakt gebracht. Hierzu kann im Verfahrensschritt 720 eine Vakuumkammer verwendet werden, wie anhand von Figur 6 erläutert. In anderen Ausführungsformen der Erfindung kann die schwefelhaltige Verbindung als Flüssigkeitsfilm auf das Substrat aufgebracht werden.

Schließlich wird im dritten Verfahrensschritt 730 eine Pulsform bzw. eine zeitliche Substruktur gewählt, mit welcher die Oberflächenmodifikation des Substrates 100 ausgeführt werden soll.

Schließlich wird im vierten Verfahrensschritt 740 die Oberfläche des Substrates 100 zumindest teilweise mit einer vorgebbaren Anzahl von Pulsen bzw. einer vorgebbaren Bestrahlungsdauer bestrahlt. Dies kann zum Einbau von Schwefelatomen in eine oberflächennahe Schicht des Substrates 100 führen. In einigen Ausführungsformen der Erfindung kann alternativ oder kumulativ die kristalline Struktur des Substrates 100 zu einer polykristallinen oder amorphen Struktur umgeschmolzen werden. Schließlich kann in einigen Ausführungsformen der Erfindung eine Aufrauhung bzw. Strukturierung mit säulenförmigen Erhebungen erfolgen.

In einigen Ausführungsformen der Erfindung kann nach der Bestrahlung mit einer ersten Pulsform und bei Anwesenheit einer ersten schwefelhaltigen Verbindung der Verfahrensschritt 720, 730 und 740 wiederholt werden, um auf diese Weise die elektrischen und/oder mechanischen Eigenschaften des Halbleiterbauelementes weiter zu optimieren. Insbesondere können auch Laserpulse auf die Oberfläche des Substrates einwirken, ohne dass eine schwefelhaltige Verbindung mit der Oberfläche in Kontakt kommt. In diesem Fall wird die umgebende Atmosphäre im Verfahrensschritt 720 entsprechend gewählt.

Nach der letzten Einwirkung von Laserpulsen bzw. der letzten Ausführung des Verfahrensschrittes 740 kann das Substrat 100 in einem optionalen Verfahrensschritt 750 getempert werden. Hierzu eignet sich eine Temperatur zwischen 340 K und 700 K, insbesondere 400 K bis 500 K. Durch das Tempern können Dotierstoffe innerhalb des Substrates 100 diffundieren und/oder elektronisch aktiviert werden. In einigen Ausführungsformen kann dieser Verfahrensschritt auch entfallen.

Im letzten Verfahrensschritt 760 werden die Kontaktschichten 220 und 230 auf die zweite Seite 102 aufgebracht, sodass elektrischer Strom aus dem Halbleiterbauelement abgeführt werden kann.

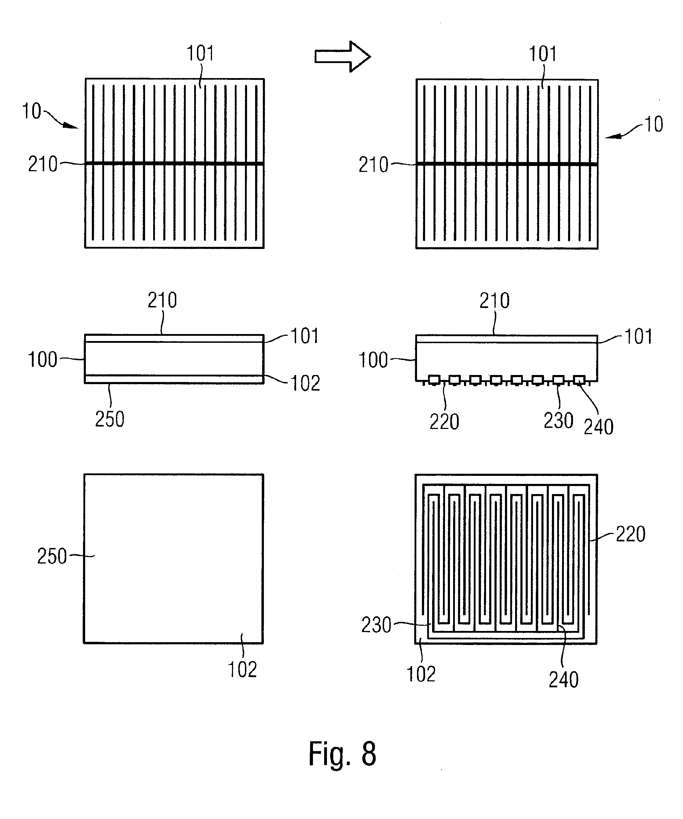

Figur 8 zeigt im linken Bildteil die Vorder- und Rückseite sowie einen Querschnitt durch eine bekannte Solarzelle. Im rechten Bildteil der Figur 8 ist die Vorder- und Rückseite sowie ein Querschnitt durch eine erfindungsgemäße Solarzelle dargestellt. Figur 8 verdeutlicht auch, wie eine bekannte Solarzelle durch wenige Verfahrensschritte zu einer erfindungsgemäßen Solarzelle strukturiert werden kann.

Figur 8 zeigt in der ersten Spalte die Aufsicht auf die erste Seite 101 des Halbleiterbauelementes 10. Die erste Seite 101 ist als Lichteintrittsfläche ausgebildet, durch welche Licht in das Volumen des Halbleiterbauelementes 10 eintreten kann. Weiterhin ist auf der ersten Seite 101 die Kontaktschicht 210 angeordnet. Die Kontaktschicht 210 ist als Teilbeschichtung der ersten Seite 101 ausgeführt, sodass erste Teilflächen ausgebildet werden, welche von der Kontaktschicht 210 bedeckt sind und zweite Teilflächen, welche als Lichteintrittsflächen dienen können.

Die zweite Seite 102 des bekannten Halbleiterbauelementes 10 ist vollflächig mit einer Kontaktschicht 250 bedeckt. Die Kontaktschichten 250 und 210 dienen dazu, die durch die Beleuchtung des Halbleiterbauelementes 10 erzeugten Ladungsträger aus dem Volumen des Substrates 100 abzuführen und entweder als Messsignal eines Photodetektors oder als elektrische Leistung einer photovoltaischen Zelle nutzbar zu machen.

Dieses im linken Bildteil der Figur 8 dargestellte, bekannte Halbleiterbauelement weist den bereits dargestellten Nachteil auf, dass Licht mit einer Photonenenergie, welche geringer ist als die Bandlückenenergie, von der ersten Seite 101 nahezu ohne Absorption auf die zweite Seite 102 des Substrates 100 gelangt, ohne freie elektrische Ladungsträger im Substrat 100 zu erzeugen. Dieser Anteil des eingestrahlten Lichtes steht daher nicht zur Stromerzeugung zur Verfügung.

Dieses an sich bekannte Halbleiterbauelement 10 kann nun gemäß dem in Figur 7 dargestellten Verfahren zu einem erfindungsgemäßen Halbleiterbauelement weiter prozessiert werden. Hierzu ist in einem ersten Verfahrensschritt lediglich die Kontaktschicht 250 auf der zweiten Seite 102 des Substrates 100 zu entfernen. Das Entfernen der Kontaktschicht 250 kann mittels eines nass- oder trockenchemischen Ätzschrittes, durch Polieren oder Sputtern erfolgen. Die solchermaßen vorbereitete zweite Seite 102 kann dann durch Beleuchten mit entsprechend geformten Laserpulsen bei optionaler Anwesenheit einer schwefelhaltigen Verbindung zumindest teilweise modifiziert und anschließend mit Kontaktschichten 220 und 230 versehen werden, wie bereits vorstehend im Zusammenhang mit Figur 7 beschrieben. Auf diese Weise kann der in Figur 4 beschriebene Querschnitt eines Halbleiterbauelementes 10 bzw. die anhand von Figur 5 beschriebene zweite Seite 102 des Halbleiterbauelementes 10 ausgebildet werden.

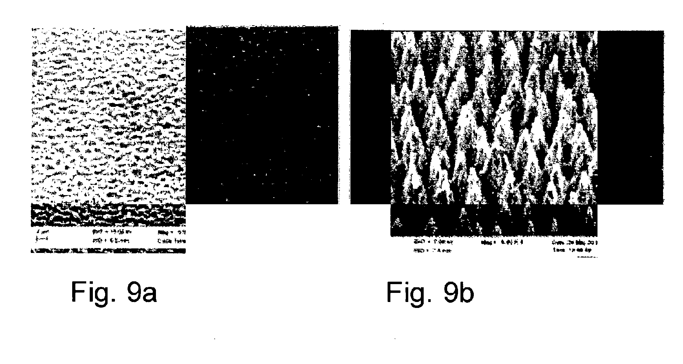

Figur 9 zeigt Aufnahmen von Flächenbereichen 240 eines Siliziumsubstrates 100, welche durch die Einwirkung von Laserpulsen unterschiedlicher Pulsformen erhalten wurden.

Die Aufnahmen gemäß Figur 9 wurden mit einem Raster-Elektronen-Mikroskop erstellt. Die Figuren 9a und 9b verdeutlichen, dass die Textur der Oberfläche in weiten Grenzen beeinflusst werden kann.

Die in Figur 9a gezeigte Oberfläche weist eine vergleichsweise flache Strukturierung auf. Hierdurch kann die Kontaktierung der Oberfläche durch eine Kontaktschicht 230 verbessert werden. Eine Verbesserung der Kontaktierung wird dabei angenommen, wenn der Übergangswiderstand zwischen dem Substrat 100 und der Kontaktschicht 230 geringer und/oder die Haftfestigkeit der Kontaktschicht 230 auf der zweiten Seite 102 des Substrates 100 vergrößert ist.

Figur 9b zeigt einen Oberflächenbereich 240, welcher tiefer strukturiert ist. Auf diese Weise wird die Lichtabsorption gegenüber der in Figur 9a gezeigten Oberfläche verbessert, sodass eine vorgebbare optische Intensität eine größere Ladungsmenge im Substrat 100 erzeugen kann. Das erfindungsgemäße Verfahren erlaubt somit, Teilflächen 240 der zweiten Seite 102 des Substrates 100 in unterschiedlicher Weise zu strukturieren, sodass jede Teilfläche die ihr zugedachte Aufgabe optimal erfüllen kann.

Selbstverständlich ist die Erfindung nicht auf die in den Figuren dargestellten Ausführungsformen beschränkt. Die vorstehende Beschreibung ist daher nicht als beschränkend, sondern als erläuternd anzusehen. Die nachfolgenden Ansprüche sind so zu verstehen, dass ein genanntes Merkmal in zumindest einer Ausführungsform der Erfindung vorhanden ist. Dies schließt die Anwesenheit weiterer Merkmale nicht aus. Sofern die Ansprüche und die vorstehende Beschreibung "erste" und "zweite" Merkmale definieren, so dient diese Bezeichnung der Unterscheidung zweier gleichartiger Merkmale, ohne eine Rangfolge festzulegen.

## Patentansprüche

1. Verfahren zur Herstellung eines Licht absorbierenden Halbleiterbauelementes (10), enthaltend die folgenden Schritte:
Bereitstellen eines Substrates (100) mit einer ersten Seite (101) und einer zweiten Seite (102), welches p-dotiertes Silizium enthält oder daraus besteht,
Einbringen eines Dotierstoffes in zumindest ein an die erste Seite (101) angrenzendes Teilvolumen (110) des Halbleitersubstrates (100), so dass zwischen dem Teilvolumen (110) und dem Halbleitersubstrat (100) ein erster pn-Übergang (21) mit einer ersten Bandlückenenergie ausgebildet wird,
Bestrahlen zumindest einer Teilfläche (240) der zweiten Seite (205) des Halbleitersubstrates (100) unter Anwesenheit einer stickstoffhaltigen, phosphorhaltigen, schwefelhaltigen oder arsenhaltigen Verbindung mit einer Mehrzahl von Laserpulsen (400) einer vorgebbaren Länge, wobei die Pulsform der Laserpulse (400) durch Modulation der Amplitude und/oder der Polarisation an zumindest eine vorgebbare Sollform angepasst wird, so dass zumindest die Teilfläche (240) der zweiten Seite (102) mit einer Oberflächenmodifikation versehen wird, wobei sich ein zweiter pn-Übergang (22) mit einer zweiten Bandlückenenergie ausbildet, wobei
die zweite Bandlückenenergie geringer ist als die erste Bandlückenenergie und
die Oberflächenmodifikation eine Aufrauhung bzw. Strukturierung umfasst und/oder die kristalline Struktur des Substrates (100) zu einer polykristallinen oder amorphen Struktur umgeschmolzen wird.

2. Verfahren nach Anspruch 1, **dadurch gekennzeichnet, dass** das Halbleitersubstrat (100) einer schwefelhaltigen Verbindung ausgesetzt wird, während zumindest ein Laserpuls (400) auf die Oberfläche (240) des Substrates (100) auftrifft.

3. Verfahren nach einem der Ansprüche 1 oder 2, **dadurch gekennzeichnet, dass** die vorgebbare Länge der Laserpulse (400) etwa 10 fs bis etwa 1 ns beträgt.

4. Verfahren nach einem der Ansprüche 1 bis 3, **dadurch gekennzeichnet, dass** die Amplitude eines einzelnen Laserpulses (400) so moduliert wird, dass dieser drei Maxima aufweist, wobei zumindest ein Maximum eine erste Amplitude aufweist und zumindest ein Maximum eine zweite Amplitude aufweist.

5. Verfahren nach einem der Ansprüche 1 bis 4, **dadurch gekennzeichnet, dass** in einem nachfolgenden Verfahrensschritt zumindest eine Teilfläche des Halbleitersubstrates (100) mit einer Kontaktschicht (210, 220, 230) versehen wird.

6. Verfahren nach einem der Ansprüche 1 bis 5, **dadurch gekennzeichnet, dass** das Halbleitersubstrat (100) nach der Bestrahlung mit einer Mehrzahl von Laserpulsen (400) getempert wird.

7. Verfahren nach einem der Ansprüche 1 bis 6, **dadurch gekennzeichnet, dass** die Amplitude eines einzelnen Laserpulses (400) so moduliert wird, dass dieser zumindest zwei Maxima aufweist, wobei die Amplitude zwischen den Maxima für eine Zeitspanne von weniger als 5 fs auf einen Wert von weniger als 15% des größeren Maximalwertes abfällt.

8. Halbleiterbauelement (10) zur Wandlung elektromagnetischer Strahlung in elektrische Energie, enthaltend ein kristallines Halbleitersubstrat (100) mit einer ersten Seite (101) und einer gegenüberliegenden zweiten Seite (102), welches p-dotiertes Silizium enthält oder daraus besteht,
wobei zumindest in einem an die erste Seite angrenzendem Teilvolumen (110) des Halbleitersubstrates (100) ein Dotierstoff eingebracht ist, so dass zwischen dem Teilvolumen (110) und dem Halbleitersubstrat (100) ein erster pn-Übergang (21) ausgebildet ist,
**dadurch gekennzeichnet, dass**
zumindest eine erste Teilfläche (240) der zweiten Seite (102) mit einem Dotierstoff und einer Oberflächenmodifikation versehen ist, so dass ein zweiter pn-Übergang (22) ausgebildet ist, wobei der Dotierstoff ausgewählt ist aus N und/oder P und/oder As und/oder S und die Oberflächenmodifikation eine Aufrauhung bzw. Strukturierung umfasst und/oder die kristalline Struktur des Substrates (100) zu einer polykristallinen oder amorphen Struktur umgeschmolzen wurde, so dass der erste pn-Übergang (21) dazu eingerichtet ist, Licht mit einer Photonenenergie oberhalb der Bandlückenenergie des Halbleitersubstrates (100) zu absorbieren und
der zweite pn-Übergang (21) dazu eingerichtet ist Licht mit einer Photonenenergie unterhalb der Bandlückenenergie des Halbleitersubstrates (100)zu absorbieren.

9. Halbleiterbauelement nach Anspruch 8, **dadurch gekennzeichnet, dass** die Oberflächenmodifikation der ersten Teilfläche eine Mehrzahl säulenförmiger Erhebungen aufweist, welche einen Durchmesser von etwa 0,3 µm bis etwa 1 µm und eine Längsersteckung von etwa 1 µm bis etwa 5 µm aufweist.

10. Halbleiterbauelement nach Anspruch 8 oder 9, **dadurch gekennzeichnet, dass** die erste Teilfläche (240) polykristallines Silizium mit einer Korngröße von 1 µm bis 100 µm enthält.

11. Halbleiterbauelement nach einem der Ansprüche 8 bis 10, **dadurch gekennzeichnet, dass** die erste Seite (101) mit zumindest einer Kontaktschicht (210) versehen ist, welche als Teilbeschichtung der ersten Seite (101) ausgeführt ist und das die zweite Seite (102) mit zumindest zwei Kontaktschichten (220, 230) versehen ist.

12. Halbleiterbauelement nach einem der Ansprüche 8 bis 11, **dadurch gekennzeichnet, dass** eine Kontaktschicht (220) der zweiten Seite einen elektrischen Kontakt zum Halbleitersubstrat (100) herstellt und die andere Kontaktschicht (230) einen elektrischen Kontakt zur ersten Teilfläche (240) der zweiten Seite (102) herstellt.

13. Halbleiterbauelement nach einem der Ansprüche 8 bis 12, **dadurch gekennzeichnet, dass** die Kontaktschicht (210) auf der ersten Seite (101) mit der Kontaktschicht (220) auf der zweiten Seite (102) eine erste photovoltaische Zelle bildet und die Kontaktschicht (210) der ersten Seite mit der Kontaktschicht (230) der zweiten Seite (102) eine zweite photovoltaische Zelle bildet, welche monolithisch auf einem Halbleitersubstrat (100) integriert sind.

14. Halbleiterbauelement nach Anspruch 13, **dadurch gekennzeichnet, dass** die erste und die zweite photovoltaische Zelle parallel miteinander verschaltet sind.

## Claims

1. Method for producing a light absorbing semiconductor device (10), comprising the following steps:
providing a substrate (100) having a first side (101) and a second side (102) and containing or consisting of p-doped silicon,
introducing a dopant into at least one partial volume (110) of the semiconductor substrate (100), said partial volume bordering on the first side (101), so as to form a first pn junction (21) having a first band gap energy between the partial volume (110) and the semiconductor substrate (100),
irradiating at least one subarea (240) of the second side (205) of the semiconductor substrate (100) in the presence of a nitrogen-containing, phosphorus-containing, sulfur-containing or arsenic-containing compound with a plurality of laser pulses (400) of presettable width, wherein the pulse shape of the laser pulses (400) is adapted to at least one settable target shape by modulation of the amplitude and/or the polarization so as to provide at least the subarea (240) of the second side (102) with a surface modification, wherein a second pn junction (22) having a second band gap energy is formed, wherein
the second band gap energy is less than the first band gap energy and
the surface modification, comprises a roughening or structuring and/or the crystalline structure of the substrate (100) is remelted into a polycrystalline or amorphous structure.

2. Method according to claim 1, **characterized in that** the semiconductor substrate (100) is exposed to a sulfur-containing compound while at least one laser pulse (400) impinges on the surface (240) of the substrate (100).

3. Method according to claim 1 or 2, **characterized in that** the presettable width of the laser pulses (400) is about 10 fs to about 1 ns.

4. Method according to any of claims 1 to 3, **characterized in that** the amplitude of an individual laser pulse (400) is modulated in such a way that it has three maximums, wherein at least one maximum has a first amplitude and at least one maximum has a second amplitude.

5. Method according to any of claims 1 to 4, **characterized in that** in a subsequent method step at least one subarea of the semiconductor substrate (100) is provided with a contact layer (210, 220, 230).

6. Method according to any of claims 1 to 5, **characterized in that** the semiconductor substrate (100) is tempered after the irradiation with a plurality of laser pulses (400).

7. Method according to any of claims 1 to 6, **characterized in that** the amplitude of an individual laser pulse (400) is modulated in such a way that it has at least two maximums, wherein the amplitude between the maximums drops to a value of less than 15 % of the greater maximum value for an interval of less than 5 fs.

8. Semiconductor device (10) for converting electromagnetic radiation into electrical energy, containing a crystalline semiconductor substrate (100) having a first side (101) and an opposite second side (102), which contains or consists of p-doped silicon,
wherein a dopant is introduced at least into a partial volume (110) of the semiconductor substrate (100), said partial volume bordering on the first side, so as to form a first pn junction (21) between the partial volume (110) and the semiconductor substrate (100),
**characterized in that**
at least one first subarea (240) of the second side (102) is provided with a dopant and a surface modification so as to form a second pn junction (22), wherein the dopant is selected from N and/or P and/or As and/or S and the surface modification comprises a roughening or structuring and/or the crystalline structure of the substrate (100) has been remelted into a polycrystalline or amorphous structure in such a way that the first pn junction (21) is adapted to absorb light with a photon energy above the band gap energy of the semiconductor substrate (100) and
the second pn junction (21) is adapted to absorb light with a photon energy below the band gap energy of the semiconductor substrate (100).

9. Semiconductor device according to claim 8, **characterized in that** the surface modification of the first subarea has a plurality of columnar elevations, which has a diameter of about 0.3 µm to about 1 µm and a longitudinal extension of about 1 µm to about 5 µm.

10. Semiconductor device according to claim 8 or 9, **characterized in that** the first subarea (240) contains polycrystalline silicon having a grain size of 1 µm to 100 µm.

11. Semiconductor device according to any of claims 8 to 10, **characterized in that** the first side (101) is provided with at least one contact layer (210) which is made as a partial coating of the first side (101) and that the second side (102) is provided with at least two contact layers (220, 230).

12. Semiconductor device according to any of claims 8 to 11, **characterized in that** a contact layer (220) of the second side establishes an electrical contact to the semiconductor substrate (100) and the other contact layer (230) establishes an electrical contact to the first subarea (240) of the second side (102).

13. Semiconductor device according to any of claims 8 to 12, **characterized in that** the contact layer (210) on the first side (101) forms a first photovoltaic cell with the contact layer (220) on the second side (102) and the contact layer (210) of the first side forms a second photovoltaic cell with the contact layer (230) of the second side (102), said photovoltaic cells being integrated monolithically on a semiconductor substrate (100).

14. Semiconductor device according to claim 13, **characterized in that** the first and second photovoltaic cells are connected in parallel.

## Revendications

1. Procédé pour la fabrication d'un composant semi-conducteur (10) absorbant la lumière, comprenant les étapes suivantes :
préparation d'un substrat (100) avec un premier côté (101) et un second côté (102), qui contient ou qui est constitué par du silicium à dopage p⁻, introduction d'un produit de dopage dans au moins un volume partiel (110), adjacent au premier côté (101), du substrat senti-conducteur (100) de telle façon qu'une première transition pn (21) avec une première énergie de bande interdite est réalisée entre le volume partiel (110) et le substrat semi-conducteur (100),
irradiation d'au moins une surface partielle (240) du second côté (205) du substrat semi-conducteur (100) en présence d'un composé contenant de l'azote, du phosphore, du soufre ou de l'arsenic, avec une pluralité d'impulsions laser (400) ayant une longueur prédéterminée, dans lequel la forme des impulsions laser (400) est ajustée, par modulation de l'amplitude et/ou de la polarisation, à au moins une forme de consigne prédéterminée, de sorte que qu'au moins la surface partielle (240) du second côté (102) est dotée d'une modification de surface, et il se forme une seconde transition pn (22) avec une seconde énergie de bande interdite, et
la seconde énergie de bande interdite est plus faible que la première énergie de bande interdite, et
la modification de surface inclut une rugosité ou une structuration, et/ou la structure cristalline du substrat (100) est transformée par fusion en une structure polycristalline ou une structure amorphe.

2. Procédé selon la revendication 1, **caractérisé en ce que** le substrat semi-conducteur (100) est exposé à un composé contenant du soufre, pendant qu'au moins une impulsion laser (400) tombe sur la surface (240) du substrat (100).

3. Procédé selon l'une des revendications 1 ou 2, **caractérisé en ce que** la longueur prédéterminée de l'impulsion laser (400) s'élève d'environ 10 fs jusqu'à environ 1ns.

4. Procédé selon l'une des revendications 1 à 3, **caractérisé en ce que** l'amplitude d'une impulsion laser individuelle (400) est modulée de telle façon que celle-ci comprend trois maximums, et de préférence un maximum présente une première amplitude et au moins un maximum présente une seconde amplitude.

5. Procédé selon l'une des revendications 1 à 4, **caractérisé en ce que**, dans une étape suivante du procédé, au moins une surface partielle du substrat semi-conducteur (100) est pourvue d'une couche de contact (210, 220, 230).

6. Procédé selon l'une des revendications 1 à 5, **caractérisé en ce qu'**après l'irradiation avec une pluralité d'impulsions laser (400) le substrat semi-conducteur (100) est tempéré.

7. Procédé selon l'une des revendications 1 à 6, **caractérisé en ce que** l'amplitude d'une impulsion laser individuelle (400) est modulée de telle façon que celle-ci comprend au moins deux maximums, et l'amplitude entre les maximums tombe, pour une durée de moins de 5fs, à une valeur inférieure à 15 % de la plus grande valeur maximale.

8. Composant semi-conducteur (10) pour la conversion de rayonnement électromagnétique en énergie électrique, contenant un substrat semi-conducteur cristallin (100) avec un premier côté (101) et un second côté opposé (102), qui contient ou qui est constitué par du silicium à dopage p⁻,
dans lequel un agent de dopage est introduit au moins dans un volume partiel (110), adjacent au premier côté, du substrat semi-conducteur (100), de telle sorte qu'une première transition pn (21) est réalisée entre le volume partiel (110) et le substrat semi-conducteur (100),
**caractérisé en ce que**
au moins une première surface partielle (240) du second côté (102) est dotée d'un agent de dopage et d'une modification de surface, de telle sorte qu'une seconde transition pn (22) est réalisée, et l'agent de dopage est choisi parmi N et/ou P et/ou As et/ou S, et la modification de surface inclut une rugosité ou une structuration, et/ou la structure cristalline du substrat (100) a été transformée par fusion en une structure polycrystalline ou une structure amorphe, de sorte que la première transition pn (21) est organisée pour absorber la lumière avec une énergie photonique au-dessus de l'énergie de bande interdite du substrat semi-conducteur (100), et
la seconde transition pn est organisée pour absorber la lumière avec une énergie photonique au-dessous de l'énergie de bande interdite du substrat semi-conducteur (100).

9. Composant semi-conducteur selon la revendication 8, **caractérisé en ce que** la modification de surface de la première surface partielle comprend une pluralité de surélévations en forme de colonnes, qui présentent un diamètre d'environ 0,3 µm à environ 1 µm, et une extension en longueur d'environ 1 µm à environ 5 µm.

10. Composant semi-conducteur selon la revendication 8 ou 9, **caractérisé en ce que** la première surface partielle (240) contient du silicium polycristallin avec une taille de grains de 1 µm à 100 µm.

11. Composant semi-conducteur selon l'une des revendications 8 à 10, **caractérisé en ce que** le premier côté (101) est doté d'au moins une couche de contact (210), laquelle est réalisée sous forme de revêtement partiel du premier côté (101), et **en ce que** le second côté (102) est pourvu d'au moins deux couches de contact (220, 230).

12. Composant semi-conducteur selon l'une des revendications 8 à 11, **caractérisé en ce qu'**une couche de contact (220) du second côté établit un contact électrique vers le substrat semi-conducteur (100), et l'autre couche de contact (230) établit un contact électrique vers la première surface partielle (240) du second côté (102).

13. Composant semi-conducteur selon l'une des revendications 8 à 12, **caractérisé en ce que** la couche de contact (210) sur le premier côté (101) forme avec la couche de contact (220) sur le second côté (102) une première cellule photovoltaïque, et la couche de contact (210) du premier côté forme avec la couche de contact (230) du second côté (102) une seconde cellule photovoltaïque, lesquelles sont intégrées de façon monolithique sur un substrat semi-conducteur (100).

14. Composant semi-conducteur selon la revendication 13, **caractérisé en ce que** la première et la seconde cellule photovoltaïque sont branchées en parallèle l'une avec l'autre.
